(19) Europäisches Patentamt
European Patent Office
Office européen des brevets

(11) Veröffentlichungsnummer: **0 124 943**
**B1**

(12) # EUROPÄISCHE PATENTSCHRIFT

(45) Veröffentlichungstag der Patentschrift: **29.10.86**

(51) Int. Cl.[4]: **C 03 C 10/00**, C 03 C 4/16

(21) Anmeldenummer: **84200630.6**

(22) Anmeldetag: **03.05.84**

(54) **Dielektrisches Glas für Mehrschichtschaltungen und damit versehene Dickfilmschaltungen.**

(30) Priorität: **06.05.83 NL 8301604**

(43) Veröffentlichungstag der Anmeldung: **14.11.84 Patentblatt 84/46**

(45) Bekanntmachung des Hinweises auf die Patenterteilung: **29.10.86 Patentblatt 86/44**

(84) Benannte Vertragsstaaten: **BE CH DE FR GB IT LI NL SE**

(56) Entgegenhaltungen:
**AU - A - 487 133**
**FR - A - 1 295 938**
**US - A - 3 656 984**
**US - A - 4 029 897**

(73) Patentinhaber: **N.V. Philips' Gloeilampenfabrieken, Groenewoudseweg 1, NL-5621 BA Eindhoven (NL)**

(72) Erfinder: **Joormann, Hendrik Jacobus Maria, c/o INT. OCTROOIBUREAU B.V. Prof. Holstlaan 6, NL-5656 AA Eindhoven (NL)**
Erfinder: **Van Gorp, Alois Jozef Maria, c/o INT. OCTROOIBUREAU B.V. Prof. Holstlaan 6, NL-5656 AA Eindhoven (NL)**

(74) Vertreter: **Auwerda, Cornelis Petrus et al, INTERNATIONAAL OCTROOIBUREAU B.V. Prof. Holstlaan 6, NL-5656 AA Eindhoven (NL)**

**EP 0 124 943 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf ein dielektrisches Glas und die daraus erhaltene Glaskeramik zum Trennen sich kreuzender Leiter in Mehrschichtschaltungen und auf die damit versehenen Dickfilmschaltungen.

In der CA-A-842 293 ist eine Glaskeramik für eine darartige Verwendung beschrieben. Diese Glaskeramik hat eine Zusammensetzung in Gew.%, die sich innerhalb der folgenden Grenzwerte befindet:

| | |
|---|---|
| $SiO_2$ | 20 - 38 |
| PbO | 21 - 45 |
| $Al_2O_3$ | 1 - 25 |
| $TiO_2$ | 2 - 20 |
| BaO | 2 - 15 |

wobei ZnO bis zu einem Maximum von 25 Gew.% vorhanden sein kann und, wie aus den Beispielen hervorgeht, meistens auch vorhanden ist. Ausserdem sind bis zu bestimmten Maxima eine Anzahl Zusätze erlaubt, namentlich $PbF_2$, SrO, $ZrO_2$, $Ta_2O_5$, $WO_3$, CdO, $SnO_2$ und $Sb_2O_3$.

Beim Abschrecken einer geschmolzenen Zusammensetzung innerhalb der obengenannten Grenzen wird eine Glasfritte erhalten, die nach Mahlen zu einer Siebdruckpaste verarbeitet werden kann. Nach dem Siebdrucken wird die Paste ausgebrannt. Dabei findet Keimbildung statt mit einer nachfolgenden Ausscheidung aus einer kristallinen Phase auf den Keimen. Die auf diese Weise erhaltene Glaskeramik weist eine niedrige Dielektrizitätkonstante auf, die vermeidet, dass bei Gebrauch von Wechselspannung zwischen den gegeneinander isolierten Schaltungsanordnungen eine kapazitive Kopplung stattfindet. Weiterhin hat die Glaskeramik niedrige dielektrische Verluste (einen hohen Q-Wert), die eine dielektrische Erhitzung derselben vermeidet, eine geringe Neigung zur Bildung von «pin-holes» sowie eine geringe Gasentwicklung beim Brennen.

Die Glaskeramik hat einen Anteil an kristalliner Phase, der zwischen 25 und 50 Gew.% liegt. Es hat sich herausgestellt, dass bei einem höheren Anteil an kristalliner Phase die Gefahr von Porosität des glaskeramischen Substrates grösser wird.

Bekannt sind Leiterpasten auf Basis von Gold als Material für den Leiter.

Bei den Versuchen, die zu der vorliegenden Erfindung führten, hat es sich herausgestellt, dass die bekannten Glaskeramiken Mikroporen aufweisen. Diese Mikroporen sind im allgemeinen unschädlich; nur bei Verwendung silberhaltiger Leiterpasten, beispielsweise AgPd, verursachen diese Mikroporen bei einer Feuchtprobe unter elektrischer Spannung Silbermigration, wodurch der Isolierwiderstand bleibend niedrig wird.

Die Erfindung schafft nun ein Glas und eine daraus erhaltene Glaskeramik, die diese Nachteile nicht aufweist und in Mehrschichtschaltungen, in denen silberhaltige Leiterpasten verwendet werden, gut verwendbar ist.

Die erfindungsgemässe Glaskeramik weist dazu das Kennzeichen auf, dass sie eine Zusammensetzung in Mol % aufweist und zwar innerhalb der folgenden Grenzwerte:

| | |
|---|---|
| ZnO | 10 - 25 |
| PbO | 7,5 - 25 |
| $SiO_2$ | 50 - 60 |
| $Al_2O_3$ | 7,5 - 12,5 |

Dieses Glas, das nichtstörende Verunreinigungen unterhalb zulässigen Maximalwerte enthalten kann, wird auf bekannte Weise zu einer Paste verarbeitet. Die Paste wird mittels eines Siebdruckverfahrens in einer Mehrschichtschaltung verarbeitet.

Die letzten Endes erhaltene Mehrschichtschaltung wird bei einer Temperatur von 840 - 900°C gebrannt über eine Dauer von $^1/_2$ bis 1 Stunde. Die Gläser nach der Erfindung haben eine Erweichungstemperatur (d.h. die Temperatur, bei der die Viskosität $\eta = 10^{7,65}$ d Pa s beträgt) zwischen 720 und 800°C, die um 50 - 180°C unterhalb der Brenntemperatur liegt. Dies ist besonders günstig, weil dann das Glas bei der Brenntemperatur ausreichend fliesst, womit sich die Poren schliessen. Es ist auch von Bedeutung, dass das Kristallisierungsverhalten des Glases bei den in Betracht kommenden thermischen Bearbeitungen derartig ist, dass die erhaltene Glaskeramik einen Anteil von 10 bis 20 Gew.-% an kristalliner Phase enthält. Die Temperatur, bei der die Kristallisierung startet, muss in einem Temperaturbereich von etwa 750 - 800°C liegen. Die kristallinen Phasen, die dabei auftreten, sind $Zn_2SiO_4$, $PbAlSi_2O_8$ und $Zn(AlO_2)_2$. Wenn die Kristallisierung erst bei höherer Temperatur beginnen würde, entstände die Gefahr, dass die Leiter in die Glasschicht einsinken und örtlich brechen, und zwar infolge einer zu niedrigen Viskosität des Glases. Ein Anteil an kristalliner Phase von 10 - 20 Gew.-% ist niedrig genug, um ein Produkt zu haben, das ohne durchgehende Mikroporen ist. Andererseits ist die Menge kristalliner Phase gross genug, um beim Brennen eine solche Festigkeit zu gewährleisten, dass vermieden wird, dass die Leiterbahnen in die Schicht des glaskeramischen Materials einsinken und dadurch örtlich Bruchstellen aufweisen. Das Material der Leiterbahnen sintert nämilch bereits ab etwa 600°C zu einem starren ziemlich spröden Ganzen. Zum Schluss ist es vorteilhaft, dass Gasblasen, wenn sie in der Zusammensetzung der Erfindung auftreten oder beim Brennen entstehen, äusserst klein sind und die Neigung zur Vergrösserung derselben vermieden wird.

Ein bevorzugtes Gebiet von Zusammensetzungen, die eine Erweichungstemperatur zwischen 750 und 800°C aufweisen, ist wie folgt begrenzt:

| | |
|---|---|
| ZnO | 15 - 20 |
| PbO | 10 - 15 |
| $SiO_2$ | ≤ 60 und |
| $Al_2O_3$ | 7,5 - 12,5. |

Den Zusammensetzungen nach der Erfindung können maximal 5 Gew.-% Farboxide, wie Kobaltoxide, Nickeloxide, Kupferoxide, Vanadiumoxide, Chrom oxide usw., Gemische oder Aluminate der Oxide hinzugefügt werden. Das Oxid kann dem Glas sowie der Paste zugefügt werden.

Die Leiterbahnen, die sich nach Beendigung der Herstellung der Schaltungsanordnung auf der Glaskeramik nach der Erfindung befinden, sind nicht lötbar. Dies hat seine Ursache darin, dass Glas bei der Herstellung des Schaltungsmusters, d.h. beim Brennen, in die Leiterschicht diffundiert. Dies ist für einige Anwendungsbereiche nachteilig.

Dieser Nachteil kann gemäss einer besonderen Abwandlung der Zusammensetzung nach der Erfindung dadurch aufgehoben werden, dass diese mit einem in dem Glas bzw. der Glaskeramik schlecht löslichen Oxid oder einer oxidischen Verbindung in fein verteilter Form und in einer Menge von 20-40 Gew.-%, dies abhängig vom spezifischen Gewicht, gefüllt wird. Beispiele solcher schlecht löslicher Oxide oder oxidischer Verbindungen sind $ZrO_2$, Zirkonaluminat, Zirkonsilikat und Aluminiumoxid. Das auf diese Weise gefüllte Material kann als dielektrische Trennschicht benutzt werden, aber es kann auch als Zwischenschicht auf einer nicht-gefüllten Schlicht verwendet werden. Meistens ist die gefüllte Schicht porös. In diesem Fall ist die Kombination mit einer nicht-gefüllten Schicht erforderlich, um eine Silbermigration zu vermeiden. Die Leiterbahnen auf einer derartigen gefüllten Schicht sind durchaus lötbar. Dadurch können auf der Schaltungsanordnung unmittelbar Bauelemente angeordnet werden, was äusserst vorteilhaft ist.

Eine andere Möglichkeit, eine Silbermigration zu vermeiden, ist das Hinzufügen eines Oxids, wie eines Zinkoxids oder Magnesiumoxids, das sich zwar zunächst im Glas löst, das jedoch danach die Menge an kristalliner Phase vergrössert. Auch in diesem Fall ist die Kombination mit einer Schicht des nichtdotierten Glases wegen der auftretenden Porosität meistens notwendig.

Ein Vorteil der Glaszusammensetzungen nach der Erfindung ist darin zu sehen, dass $B_2O_3$, $Na_2O$ und $K_2O$ in einer Menge, die grösser ist als 1 Mol %, fehlen, und dass Fluoride, Halogenide, Schwefelverbindungen, Phosphorverbindungen, Molybdänoxide und Wolframoxide in einer Menge, die grösser ist als 0,1 Mol %, fehlen; Alkalixode und Borsäure würden das Kristallisierungsverhalten ungünstig beeinflussen. Ausserdem können die genannten Stoffe, die alle bei der Brenntemperatur mehr oder weniger flüchtig sind, die Eigenschaften anderer Schaltungsteile beeinträchtigen.

Als Beispiel wird nun die Herstellung einer Mehrschichtschaltung mit Hilfe der Dickfilmtechnik beschrieben.

Auf einem für Dickfilmtechnik üblichen Substrat, beispielsweise bestehend aus 96% Aluminiumoxid, wird durch Siebdrucken ein Leitermuster angebracht und zwar mittels einer Paste auf Basis von Ag-Pd, beispielsweise nur 23 Gew.-% Pd und 67 Gew.-% Ag, der Glas und $Bi_2O_3$ in einer Gesamtmenge von 10 Gew.-% hinzugefügt sind. Darauf wird ebenfalls durch Siebdrucken ein Muster der Glaskeramik nach der Erfindung angebracht, versehen mit Öffnungen, «Via's» genannt, die elektrische Verbindungen zwischen den Leitern herstellen müssen.

Zum Erhalten des Glaspulvers einer der sechs Zusammensetzungen in der unterstehenden Tabelle wird ein Gemisch der betreffenden Oxide geschmolzen, die Schmelze abgeschreckt und die erhaltene Fritte auf eine mittlere Korngrösse von 2 µm gemahlen. Das Pulver wird in einer Dreiwalzenmühle zu einer Siebdruckpaste verarbeitet, wobei mit Hilfe einer Lösung von 4,5 Gew.-% Äthylcellulose in einem Gemisch, das aus 23 Gew.-% Butyldiglykolacetat, 13 Gew.-% Dibutylphthalat und 64 Gew.-% Terpineol besteht, die gewünschte Viskositätscharakteristik erreicht wird. Die Paste enthält 40 Gew.-% Glaspulver.

Die Isolierschicht wird in zwei Schritten mit je einer Schichtdicke von 40-50 µm in nassem Zustand mit zwischenzeitlicher Trocknung angebracht und darauf, ebenfalls durch Siebdrucken, ein zweites Leitermuster auf Basis von Ag-Pd mit einer Dicke von 40-50 µm, ebenfalls in nassem Zustand gemessen, angebracht. Nach dem Trocknen wird eine Abdeckschicht mit einer Dicke von 40-50 µm derselben Zusammensetzung wie die Isolierschicht angebracht, um unerwünschte Wechselwirkungen zwischen den Schichten zu vermeiden und das Ganze wird bei einer Temperatur zwischen 840-900°C gebrannt. Dabei erfolgt eine Verdichtung auf etwa 40% der ursprünglichen Dicke. Es ist auch möglich, bei der Herstellung der Mehrschichtschaltung zwischenzeitlich eine oder mehrere Brennbearbeitungen durchzuführen statt nur einer Brennbearbeitung, wenn alle Schichten im Siebdruckverfahren angebracht und getrocknet sind.

Wenn die auf diese Weise erhaltene Mehrschichtschaltung einer Feuchtprobe in Luft mit einer Luftfeuchtigkeit von 95-98% und bei einer Temperatur von 45°C unter 30 V Gleichspannung ausgesetzt wird, wird eine Lebensdauer von mindestens 1000 Stunden festgestellt.

In der folgenden Tabelle stehen sechs Zusammensetzungen, deren Nummern 1 und 6 am Rand des obenstehend abgegrenzten Zusammensetzungsgebiets liegen und deren Eigenschaften gerade noch den Anforderungen entsprechen. Die Zusammensetzungen 2 bis 5 liegen innerhalb des obenstehend abgegrenzten Gebiets und entsprechen den gestellten Anforderungen. In der Tabelle sind angegeben die Kapazität je $mm^2$ bei 1 MHz, der Verlustwinkel ($tg\delta$), der Widerstand der Isolierschicht, der höher (+) oder niedriger (—) ist, als der Wert $10^4 M\Omega/\square$ und die Silbermigration, die niedrig genug (+) oder zu hoch (—) ist und die Erweichungstemperatur (ET) in °C. Die Eigenschaften sind an einer 35 µm dicken gebrannten Schicht auf einem genormten Zweischichtmuster gemessen.

Die Silbermigration wird mit Hilfe eines Normmusters, auf dem sich 104 Kreuzungen gefinden, festgestellt. Die Schaltungsanordnung wird 4 Stunden lang unter Gleichspannung in Wasser getaucht gehalten. Es wird visuell beurteilt, ob die Silbermigration klein genug (+) ist; es sind dann höchstens 3 Silberstellen sichtbar. Bei mehr Stellen wird die Silbermigration als zu gross beurteilt.

| Nr. | Zusammensetzung (Mol %) ZnO | PbO | $Al_2O_3$ | $SiO_2$ | (Gew.-%) ZnO | PbO | $Al_2O_3$ | $SiO_2$ | Kap. pF/mm$^2$ | tgδ (%) | R $>10^4$MΩ | Migr. | ET (°C) |
|---|---|---|---|---|---|---|---|---|---|---|---|---|---|
| 1 | 25 | 7,5 | 7,5 | 60 | 25 | 21,7 | 9,3 | 44 | 2,5 | 1,1 | — | — | 810 |
| 2 | 25 | 10 | 10 | 55 | 23,7 | 26 | 12 | 38,3 | 2,4 | 0,7 | + | + | 790 |
| 3 | 20 | 15 | 10 | 55 | 18 | 36 | 10 | 36 | 2,8 | 0,6 | + | + | 770 |
| 4 | 17,5 | 17,5 | 12,5 | 52,5 | 14,5 | 40,5 | 13 | 32 | 3,4 | 0,55 | + | + | 765 |
| 5 | 15 | 20 | 10 | 55 | 12,2 | 44,6 | 10,2 | 33 | 3,5 | 0,7 | + | + | 750 |
| 6 | 10 | 25 | 10 | 55 | 7,5 | 52 | 9,5 | 31 | 3,7 | 0,8 | — | + | 720 |

**Patentansprüche**

1. Dielektrisches Glas zur Herstellung von Glaskeramik zum Trennen sich kreuzender Leiter in Mehrschichtschaltungen, dadurch gekennzeichnet, dass es eine Zusammensetzung in Mol.% aufweist innerhalb der nachfolgenden Grenzwerte:

ZnO 10 - 25
PbO 7,5 - 25
$SiO_2$ 50 - 60
$Al_2O_3$ 7,5 - 12,5.

2. Dielektrisches Glas zur Herstellung von Glaskeramik nach Anspruch 1, dadurch gekennzeichnet, dass die Zusammensetzung in Mol.% innerhalb der folgenden Grenzen liegt:

ZnO 15 -20
PbO 10 - 15
$SiO_2$ $\leqslant$ 60 und
$Al_2O_3$ 7,5 - 12,5.

3. Dielektrisches Glas nach Anspruch 1 oder 2, dadurch abgewandelt, dass es zusätzlich ein oder mehrere Farboxide in einer Menge von höchstens 5 Gew.-% enthält.

4. Dielektrisches Glas nach einem der Ansprüche 1 bis 3, dadurch abgewandelt, dass es zusätzlich schlecht lösliches oxidisches Material in fein verteilter Form in einer Menge zwischen 20 und 40 Gew.-% enthält.

5. Dielektrisches Glas nach Anspruch 1 bis 3, dadurch abgewandelt, dass es zusätzlich oxidisches Material enthält, das sich zunächst im Glas löst, doch danach die Menge kristalliner Phase im Enderzeugnis vergrössert.

6. Glaskeramik, hergestellt aus einem Glas gemäss einem der Ansprüche 1-5.

7. Mehrschichtdickfilmschaltung, die eine dielektrische Glaskeramik zum Trennen sich kreuzender Leiter nach Anspruch 6 und gegebenfalls eine Oberflächenschicht daraus umfasst.

**Claims**

1. A dielectric glass for the manufacture of glass ceramics for separating crossing conductors in multilayer circuits, characterized in that it has a composition in mol.% within the following limiting values:

ZnO 10 - 25
PbO 7.5 - 25
$SiO_2$ 50 - 60
$Al_2O_3$ 7.5 - 12.5.

2. A dielectric glass for the manufacture of glass ceramics as claimed in Claim 1, characterized in that the composition in mol.% is within the following limits:

ZnO 15 - 20
PbO 10 - 15
$SiO_2$ $\leqslant$ 60 and
$Al_2O_3$ 7.5 - 12.5.

3. A dielectric glass as claimed in Claim 1 or 2, characterized in that it comprises in addition one or more colour oxides in a quantity of at most 5% by weight.

4. A dielectric glass as claimed in any of Claims 1 to 3, characterized in that it comprises in addition poorly soluble oxidic material in a finely-divided form and a quantity between 20 and 40% by weight.

5. A dielectric glass as claimed in Claims 1 to 3, characterized in that it comprises in addition oxidic material which in the first instance dissolves in the glass but then enhances the quantity of crystalline phase in the final product.

6. A glass ceramic produced from a glass as claimed in any of Claim 1 to 5.

7. A multilayer thick-film circuit wich comprises a dielectric glass ceramic for separating crossing conductors as claimed in Claim 6 and optionally a surface layer therefrom.

**Revendications**

1. Verre diélectrique pour la réalisation de matière vitrocristalline pour la séparation de conducteurs qui se croisent dans des circuits multicouches, caractérisé en ce qu'il présente une composition, en % en moles, située entre les valeurs limites suivantes:

| | |
|---|---|
| ZnO | 10 - 25 |
| PbO | 7,5 - 25 |
| $SiO_2$ | 50 - 60 |
| $Al_2O_3$ | 7,5 - 12,5. |

2. Verre diélectrique pour la réalisation de matière vitrocristalline selon la revendication 1, caractérisé en ce que la composition, en % en moles, se situe entre les limites suivantes:

| | |
|---|---|
| ZnO | 15 - 20 |
| PbO | 10 - 15 |
| $SiO_2$ | $\leqslant$ 60 et |
| $Al_2O_3$ | 7,5 - 12,5. |

3. Verre diélectrique selon la revendication 1 ou 2, caractérisé en ce qu'il contient en outre un ou plusieurs oxydes colorés dans une quantité d'au maximum 5% en poids.

4. Verre diélectrique selon l'une des revendications 1 à 3, caractérisé en ce qu'il contient en outre du matériau oxydique peu soluble sous forme finement divisée dans une quantité comprise entre 20 et 40% en poids.

5. Verre diélectrique selon la revendication 1 à 3, caractérisé en ce qu'il contient en outre du matériau oxydique qui se dissout dans le verre, mais qui augmente alors la quantité de phase cristalline dans le produit définitif.

6. Matière vitrocristalline réalisée à partir d'un verre selon l'une des revendications 1 à 5.

7. Circuit à couches épaisses multicouches, comprenant une matière vitrocristalline diélectrique pour la séparation de conducteurs qui se croisent selon la revendication 6 et, le cas échéant, une couche superficielle en réalisée.